# FASCICULE DE BREVET EUROPEEN

(11) **EP 2 076 942 B1**
(45) Date de publication et mention de la délivrance du brevet: **06.08.2014**
(21) Numéro de dépôt: 07858400.0
(22) Date de dépôt: 05.10.2007
(51) Int. Cl.: H01R 13/6464, H01R 13/6467, H01R 24/64

(54) **DISPOSITIF DE RACCORDEMENT POUR RÉSEAU LOCAL**
VERBINDUNGSVORRICHTUNG FÜR LAN
LINKING DEVICE FOR LOCAL AREA NETWORK

(30) Priorité: 09.10.2006 FR 0654161
(43) Date de publication de la demande: 08.07.2009
(73) Titulaire: Legrand France, 87000 Limoges (FR); Legrand SNC, 87045 Limoges (FR)
(72) Inventeur: Laroche, Vincent, 72540 Joue En Charnie (FR)
(74) Mandataire: Santarelli
(86) Numéro de dépôt international: PCT/FR2007/001630
(87) Numéro de publication internationale: WO 2008/043902

(56) Documents cités:
- WO-A-2005/093911
- FR-A1- 2 729 510
- US-A- 4 799 901
- US-B1- 6 758 698

## Description

### DOMAINE DE L'INVENTION

L'invention a trait aux dispositifs de raccordement pour réseau local (en anglais : Local Area Network) filaire.

### ARRIERE-PLAN TECHNOLOGIQUE

On sait qu'en général les câbles de réseau local sont du type à quatre paires de conducteurs torsadées et que les prises femelles et les fiches mâles employées pour le raccordement de tels câbles comportent une série de huit contacts métalliques agencés de façon prédéterminée, le plus souvent conformément au format RJ45.

On sait également que la géométrie des contacts présents dans de telles fiches et dans de telles prises n'est pas optimale sur le plan des transmissions électriques et qu'en particulier la disposition des quatre paires de contacts au sein d'une seule unité de connexion, sans séparation de masse, favorise les couplages parasites entre les différentes paires (paradiaphonie) alors que la géométrie des contacts n'est pas adaptée à l'impédance caractéristique habituelle des réseaux locaux, à savoir 100 Ohms, ce qui produit des défauts d'adaptation d'impédance et donc d'importantes pertes d'insertions.

Afin de contrebalancer ces couplages parasites et d'améliorer l'adaptation d'impédance, les dispositifs de raccordement pour réseau local comportent en général, entre les deux unités de connexion formées par exemple par les contacts d'une prise femelle RJ45 et par le bornier de raccordement à un câble de réseau local, un circuit de compensation.

Ce circuit de compensation est en général réalisé sous la forme d'un circuit imprimé rigide comportant souvent deux couches, voire davantage pour les prises à hautes performances.

Un tel circuit de compensation comporte des couplages de type inductif et capacitif, formant une cellule LC ou plusieurs cellules LC en cascade.

Les couplages inductifs (couplage magnétique ou effet inductif majeur) sont réalisés par la proximité de deux fils. La distance qui les sépare, leurs dimensions, les matériaux utilisés pour les fils et leurs supports déterminent le couplage obtenu.

Comme pour les couplages inductifs, les couplages capacitifs (couplage électrique ou effet capacitif majeur) sont réalisés par la proximité de deux conducteurs, mais c'est le couplage entre les surfaces de ces conducteurs qui est recherché. Les couplages capacitifs sont classiquement réalisés sous la forme de capacités en peigne disposées sur une même couche du circuit ou font intervenir des trous métallisés pratiqués dans l'épaisseur du circuit.

Un exemple de dispositif de raccordement pour réseau local muni d'un tel circuit de compensation est décrit par exemple dans la demande de brevet français 2 729 510.

### OBJET DE L'INVENTION

L'invention vise à fournir un tel dispositif de raccordement qui soit performant en matière de transmissions tout en étant simple et économique.

Elle propose à cet effet un dispositif de raccordement pour réseau local, comportant deux unités de connexion et un circuit de compensation muni de points de connexion pour des contacts que comportent lesdites unités de connexion et des pistes conductrices pour relier deux à deux lesdits points de connexion, ledit circuit comportant des moyens de couplage capacitif entre au moins une première dite piste conductrice et une seconde dite piste conductrice ; caractérisé en ce que lesdits moyens de couplage capacitif comportent un élément conducteur isolé électriquement desdites première piste et seconde piste tandis qu'il présente une surface comportant une portion en regard, au travers d'un diélectrique, d'une surface de même orientation d'un tronçon de la première piste et une autre portion en regard, au travers dudit diélectrique, d'une surface de même orientation d'un tronçon de la seconde piste

Du fait que l'élément conducteur n'est connecté à aucune des pistes à coupler, les composants parasites intrinsèques aux couplages capacitifs sont faibles, ce qui permet au dispositif de raccordement selon l'invention d'offrir de bonnes performances en matière de transmissions alors que le circuit de compensation qu'il comporte demeure simple et économique à mettre en oeuvre.

Selon des caractéristiques préférées, ledit diélectrique comporte un substrat interposé entre ledit élément conducteur et lesdites première piste et seconde piste.

Un tel substrat est particulièrement commode pour mettre en oeuvre le circuit de compensation, en particulier pour porter les pistes conductrices et/ou l'élément conducteur.

Selon d'autres caractéristiques préférées, ledit diélectrique comporte une matière souple en feuille.

En général, une telle matière est de faible épaisseur et à tolérance d'épaisseur réduite.

Elle est donc particulièrement avantageuse pour mettre en oeuvre les moyens de couplage capacitifs selon l'invention, étant ici rappelé que la précision d'un tel couplage dépend de la tolérance de l'épaisseur de diélectrique entre les pistes conductrices et la surface de l'élément conducteur ; et que le couplage sera d'autant plus efficace que cette épaisseur sera petite.

De préférence, pour des raisons de simplicité et de commodité de mise en oeuvre, ledit matériau souple en feuille est conformé en une bande.

Selon d'autres caractéristiques préférées, pour des questions de simplicité et de commodité de mise en oeuvre :
- ledit tronçon de la première piste et ledit tronçon de la seconde piste ont la forme d'un ruban ;
- ledit tronçon de la première piste et ledit tronçon de la seconde piste sont parallèles l'un à l'autre avec leurs bords longitudinaux internes qui sont directement en regard l'un de l'autre ;
- ledit tronçon de la première piste et ledit tronçon de la seconde piste sont disposés en peigne, avec chacune desdites première piste et seconde piste qui présentent des dents disposées de façon imbriquée ;
- ledit élément conducteur est un pavé comportant une face principale formant ladite surface ;
- ledit pavé est rectangulaire ;
- ledit élément conducteur est une vis dont ladite surface est située à une extrémité ;
- ledit dispositif comporte une portion formant écrou dans laquelle est reçu le fût de ladite vis, grâce à quoi la distance entre ladite surface d'extrémité et lesdites première piste conductrice et seconde piste conductrice peut être ajustée ;
- ledit circuit de compensation comporte une partie centrale qui est souple et deux parties d'extrémité qui sont rigides ;
- lesdits points de connexion sont prévus dans lesdites parties d'extrémité ;
- au moins une desdites unités de connexion est une unité de connexion pour une prise femelle RJ45 ;
- les deux unités dites unités de connexion sont des unités de connexion pour une prise femelle RJ45 ;
- le dispositif comporte au moins un logement d'accueil d'une fiche mâle RJ45 ; et/ou
- le dispositif comporte deux logements d'accueil d'une fiche mâle RJ45 débouchant respectivement dans l'une et l'autre de deux faces opposées d'un boîtier.

### BREVE DESCRIPTION DES DESSINS

L'exposé de l'invention sera maintenant poursuivi par la description détaillée d'exemples de réalisation, donnée ci-après à titre illustratif et non limitatif, en référence aux dessins annexés. Sur ceux-ci :
- la figure 1 est une vue en perspective montrant un dispositif de raccordement conforme à l'invention comportant deux prises femelles RJ45 reliées l'une à l'autre, et montrant deux fiches mâles RJ45 chacune disposée devant un logement d'accueil respectif de ce dispositif, dans une position où elle est prête à y être insérée ;
- la figure 2 est une vue éclatée en perspective de ce dispositif de raccordement ;
- la figure 3 est une vue en perspective d'un ensemble faisant partie du dispositif illustré sur la figure 1, cet ensemble comportant deux unités de connexion pour prise femelle RJ45 et un circuit de compensation reliant ces deux unités l'une à l'autre ;

- la figure 4 est une vue en perspective montrant isolément l'une des unités de connexion ;
- la figure 5 est une vue en perspective montrant isolément le circuit de compensation ;
- la figure 6 est un schéma électrique simplifié du circuit de compensation ;
- la figure 7 est une vue schématique en plan de l'une des deux couches externes du circuit de compensation ;
- les figures 8 et 9 sont des vues semblables, mais respectivement pour l'une et l'autre des deux couches internes du circuit de compensation ;
- la figure 10 est une vue schématique en perspective montrant une portion du circuit de compensation ; et
- les figures 11 et 13 sont des vues semblables, mais pour des variantes du circuit de compensation.

### DESCRIPTION DETAILLEE D'EXEMPLES DE REALISATION

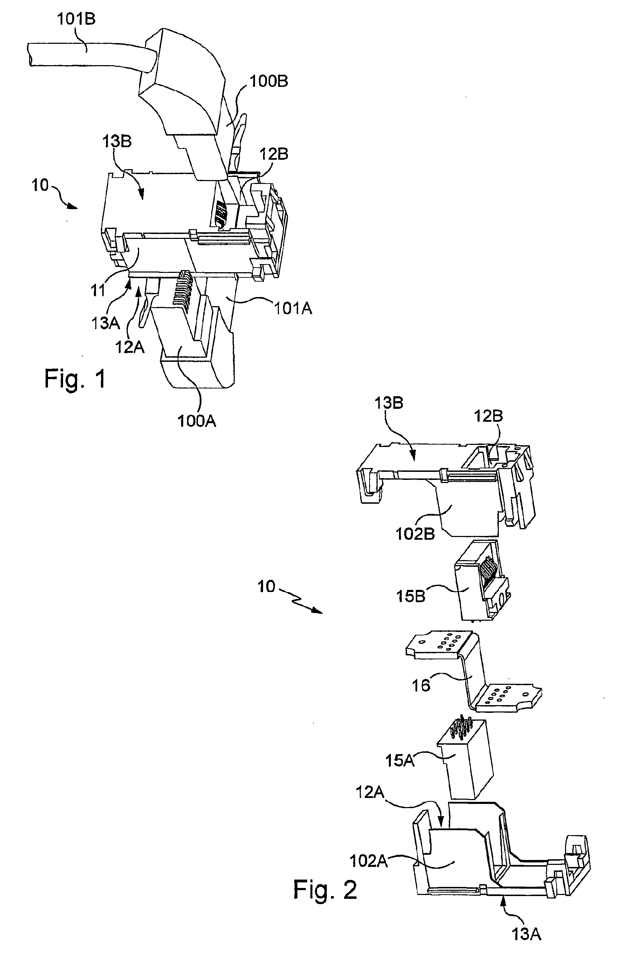

Le dispositif de raccordement 10 illustré sur les figures 1 et 2 comporte un boîtier 11 présentant deux logements 12A et 12B d'accueil d'une fiche mâle RJ45 telle que les fiches 100A et 100B représentées sur la figure 1, chacune située à une extrémité d'un câble de réseau local, respectivement 1 01A et 101 B.

Lorsque des fiches telles que 100A et 100B sont insérées respectivement dans le logement 12A et dans le logement 12B, les câbles tels que 100A et 100B sont reliés l'un à l'autre.

Les logements 12A et 12B débouchent respectivement dans une face 13A et dans une face 13B du boîtier 11, opposées l'une à l'autre.

Ici, le boîtier 11 comporte deux coquilles 102A et 102B (figure 2), identiques et disposées tête-bêche. Les coquilles 102A et 102B sont associées l'une à l'autre par encliquetage.

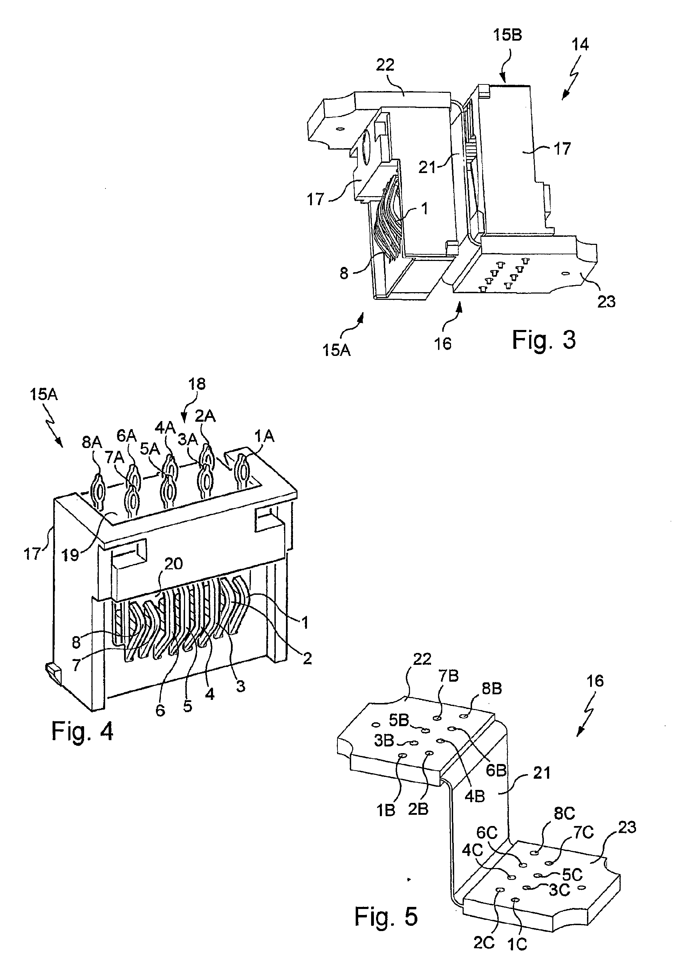

Le boîtier 11 renferme un ensemble 14 illustré à l'état assemblé sur la figure 3.

L'ensemble 14 comporte deux unités de connexion 15A et 15B prévues pour faire partie d'une prise femelle RJ45, ces deux unités étant identiques et disposées tête-bêche tandis qu'elles sont reliées l'une à l'autre par un circuit de compensation 16.

L'unité de connexion 15A sera maintenant décrite plus particulièrement à l'appui de la figure 4. Cette description vaut également pour l'unité de connexion 15B, qui est identique.

L'unité de connexion 15A comporte un support isolant 17 dans lequel est disposé un insert 18, lequel comporte une plaque isolante 19 portant huit contacts métalliques 1 à 8. Les références numériques 1 à 8 sont ici identiques à la numérotation normalisée pour les contacts des unités de connexion RJ45.

Chacun des contacts métalliques 1 à 8 comporte une partie de contact, disposée dans une fenêtre 20 du support 17, et une queue, respectivement 1A, 2A, 3A, 4A, 5A, 6A, 7A et 8A, saillant de la plaque 19 du côté opposé à la fenêtre 20.

Chaque partie de contact disposée dans la fenêtre 20 est prévue pour établir un contact électrique avec le contact métallique correspondant d'une fiche mâle RJ45 telle que 100A ou 100B introduite dans le logement 12A (12B pour l'unité de connexion 15B).

Le montage de l'unité 15A dans le dispositif 10 s'effectue par encliquetage du support 17 sur le boîtier 11, et plus précisément sur la coquille 102A (102B pour l'unité de connexion 15B), au niveau du logement 12A (12B pour l'unité de connexion 15B).

Chacune des queues 1A à 8A est prévue pour connecter le contact métallique auquel elle appartient au reste de du dispositif 10.

Ici, ces queues ont une forme en tête d'épingle et sont chacune prévues pour être introduites à force dans un orifice de connexion d'une plaque rigide de circuit imprimé.

Pour plus de détails sur les unités de connexion 15A et 15B, on pourra se reporter à la demande de brevet français 2 826 788.

Le circuit de compensation 16, illustré isolément sur la figure 5, comporte une partie centrale 21 qui est souple et deux parties d'extrémité 22 et 23, qui sont rigides.

La partie rigide 22 présente huit orifices de connexion, respectivement 1B, 2B, 3B, 4B, 5B, 6B, 7B et 8B, prévus pour accueillir les queues 1A, 2A, 3A, 4A, 5A, 6A, 7A et 8A, respectivement, de l'unité de connexion 15A.

De même, la partie d'extrémité rigide 23 présente huit orifices de connexion 1C, 2C, 3C, 4C, 5C, 6C, 7C et 8C, prévus pour les queues 1A, 2A, 3A, 4A, 5A, 6A, 7A et 8A, respectivement, de l'unité de connexion 15B.

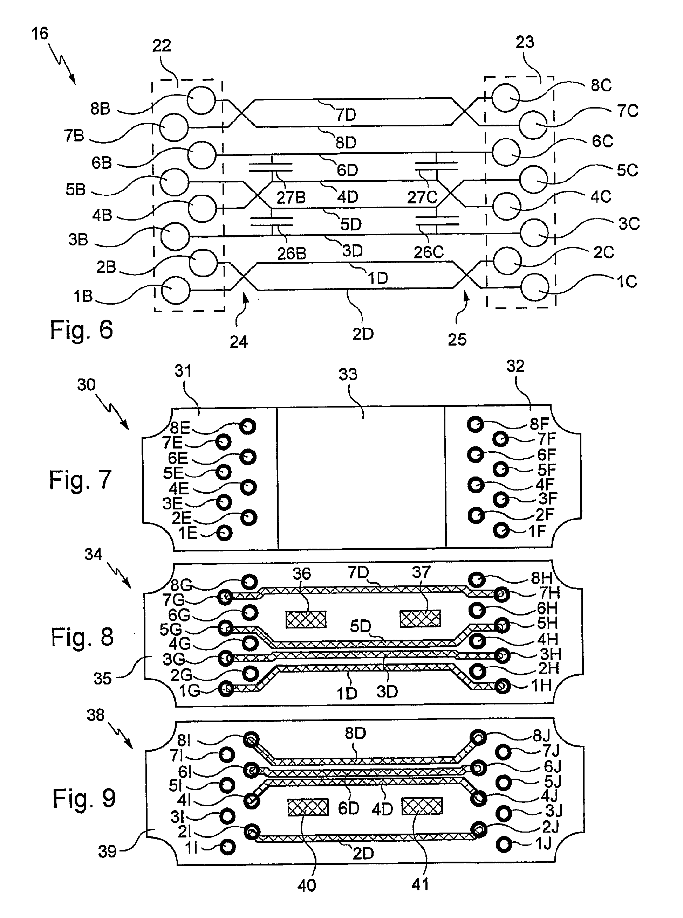

Les liaisons opérées par le circuit de compensation 16 sont illustrées schématiquement, et de façon simplifiée, sur la figure 6.

Le circuit 16 comporte huit pistes conductrices 1 D, 2D, 3D, 4D, 5D, 6D, 7D et 8D. La piste 1D relie l'orifice de connexion 1B de la partie d'extrémité 22 à l'orifice de connexion 1C de la partie d'extrémité 23. Les orifices 2B et 2C sont reliés l'un à l'autre par la piste 2D, et ainsi de suite, les orifices xB et xC étant reliés l'un à l'autre par la piste xD, avec x qui va de 1 à 8.

On voit que les pistes 1 D et 2D s'entrecroisent avec une première zone de croisement 24 située à proximité des orifices de connexion 1 B et 2B et une seconde zone de croisement 25 située à proximité des orifices de connexion 1C et 2C.

Le couple de pistes 4D, 5D ainsi que le couple de pistes 7D, 8D s'entrecroisent de la même façon.

En revanche, les pistes 3D et 6D ne croisent aucune autre piste.

On rappelle ici que, suivant le câblage normalisé des unités de connexion RJ45, les contacts 1 à 8 sont prévus pour être reliés à un câble, tel que 101A et 101 B, à huit conducteurs disposés en quatre paires torsadées aboutissant aux paires de contacts 1-2, 3-6, 4-5 et 7-8, respectivement.

L'entrecroisement des couples de pistes conductrices 1 D-2D, 4D-5D et 7D-8D produit un effet semblable à celui du torsadage des paires de conducteurs dans le câble.

Un tel entrecroisement des pistes 3D et 6D n'est par réalisable, puisque les orifices 3B et 6B (respectivement 3C et 6C) ne sont pas voisins.

Pour améliorer les performances de transmission du dispositif 10, notamment en ce qui concerne l'adaptation d'impédance de la paire 3-6 et la paradiaphonie entre la paire 3-6 et la paire 4-5, it est prévu un couplage capacitif entre les pistes 3D et 5D ainsi qu'entre les pistes 4D et 6D.

Le couplage capacitif entre les pistes 3D et 5D est réalisé par deux condensateurs 26B et 26C.

Le condensateur 26B est disposé entre les pistes conductrices 3D et 5D à proximité des orifices de connexion 3B et 4B. De même, le condensateur 26C est disposé entre les pistes conductrices 3D et 5D, mais à proximité des orifices de connexion 3C et 4C.

On observera que chacun des condensateurs 26B et 26C est disposé dans une zone où la piste conductrice 5D est, grâce à son entrecroisement avec la piste 4D, disposée en regard et à proximité de la piste 3D.

Le couplage capacitif entre les pistes 4D et 6D est lui aussi réalisé par deux condensateurs 27B et 27C, disposés d'une façon similaire.

Ainsi, le condensateur 27B est disposé entre les pistes conductrices 4D et 6D à proximité des orifices de connexion 5B et 6B tandis que le condensateur 27C est disposé entre les pistes conductrices 4D et 6D à proximité des orifices de connexion 5C et 6C, avec chacun des condensateurs 27B et 27C qui est disposé entre les pistes conductrices 4D et 6D dans une zone où, grâce à l'entrecroisement entre les pistes 4D et 5D, la piste 4D est en regard et à proximité de la piste conductrice 6D.

Les différentes couches qui composent le circuit de compensation 16 seront maintenant décrites à l'appui des figures 7 à 10.

Le circuit 16 comporte deux couches externes 30 illustrées de façon isolée sur la figure 7.

Chaque couche 30 comporte deux plaques de circuit imprimé 31 et 32 et, disposée entre les plaques 31 et 32, une bande 33 de matière isolante souple en feuille mince.

Les plaques de circuit imprimé 31 et 32 sont prévues pour faire partie respectivement de la partie rigide d'extrémité 22 et de la partie rigide d'extrémité 23. La bande 33 est quant à elle prévue pour faire partie de la partie centrale souple 21.

Dans la plaque 31 sont ménagés des orifices à pourtour métallisé 1 E, 2E, 3E, 4E, 5E, 6E, 7E et 8E servant à mettre en oeuvre les orifices de connexion 1 B à 8B, respectivement.

De même la plaque de circuit imprimé 32 présente des orifices à pourtour métallisé 1F, 2F, 3F, 4F, 5F, 6F, 7F et 8F servant à mettre en oeuvre les orifices de connexion 1C à 8C, respectivement.

La première couche interne 34 illustrée sur la figure 8 comporte une bande 35 de matière isolante souple en feuille mince formant un substrat sur lequel sont disposées les pistes conductrices 1 D, 3D, 5D et 7D ainsi que deux pavés conducteurs 36 et 37, ici de forme rectangulaire.

Dans le substrat 35 sont ménagés à une extrémité des orifices à pourtour métallisé 1G, 2G, 3G, 4G, 5G, 6G, 7G et 8G pour la mise en oeuvre des orifices de connexion 1 B à 8B, respectivement. A l'autre extrémité sont ménagés des orifices à pourtour métallisé 1H, 2H, 3H, 4H, 5H, 6H, 7H et 8H, servant à la mise en oeuvre des orifices de connexion 1C à 8C, respectivement.

Bien entendu, la piste 1D est disposée entre les orifices 1G et 1H, la piste 3D entre les orifices 3G et 3H, la piste 5D entre les orifices 3G et 3H et, enfin, la piste 7D entre les orifices 7G et 7H.

Les pavés conducteurs 36 et 37 ont une disposition semblable à celle des condensateurs 27B et 27C.

Ainsi, le pavé 36 est disposé à proximité des orifices 5G et 6G tandis que le pavé 37 est disposé à proximité des orifices 5H et 6H.

La seconde couche interne 38 illustrée sur la figure 9 comporte une bande 39 de matière isolante souple en feuille mince formant un substrat sur lequel sont disposées les pistes conductrices 2D, 4D, 6D et 8D ainsi que deux pavés conducteurs 40 et 41, ici de forme rectangulaire.

Dans le substrat 39 sont ménagés à une extrémité des orifices à pourtour métallisé 1I, 2I, 3I, 4I, 5I, 6I, 7I et 8I pour la mise en oeuvre des orifices de connexion 1 B à 8B, respectivement. A l'autre extrémité sont ménagés des orifices à pourtour métallisé 1 J, 2J, 3J, 4J, 5J, 6J, 7J et 8J, servant à la mise en oeuvre des orifices de connexion 1C à 8C, respectivement.

Bien entendu, la piste 2D est disposée entre les orifices 2I et 2J, la piste 4D est disposée entre les orifices 4I et 4J, la piste 6D est disposée entre les orifices 6I et 6G et, enfin, la piste 8D entre les orifices entre les orifices 8I et 8J.

Les pavés conducteurs 40 et 41 ont une disposition semblable à celle des condensateurs 26B et 26C.

Ainsi, le pavé 40 est disposé à proximité des orifices 3I et 4I tandis que le pavé 41 est disposé à proximité des orifices 3J et 4J.

On notera que, d'une façon générale, les orifices externes (numérotation impaire) sont reliés par des pistes conductrices portées par le substrat 35 et que les orifices internes (numérotation paire) sont reliées par des pistes conductrices portées par le substrat 39.

Dans le circuit de compensation 16, les couches internes 34 et 38 sont disposées l'une contre l'autre de sorte que les différents trous métallisés se superposent exactement (le trou 1I est superposé avec le trou 1 G, le 2I avec le trou 2G et ainsi de suite et, de même, le trou 1 J est superposé avec le trou 1 H, le trou 2H avec le trou 2J, et ainsi de suite).

Les pistes conductrices 1 D à 8D sont ainsi agencées comme décrit à l'appui de la figure 6.

Bien entendu, le caractère isolant du substrat 35 permet d'éviter les courts-circuits entre les pistes conductrices qui s'entrecroisent, chaque piste croisant une autre piste étant disposée sur une couche distincte.

L'une des couches externes 30 est disposée contre la couche 34, du côté opposé à la couche 38 tandis que l'autre couche externe 30 est disposée contre la couche 38 du côté opposé à la couche 34. Les trous métallisé 1E sont superposés aux trous métallisés 1G et 1I, les trous métallisés 2E sont superposés aux trous métallisés 2I et 2G, et ainsi de suite ; et de même les trous métallisés 1 F sont superposés aux trous métallisés 1H et 1J, les trous métallisés 2F sont superposés aux trous métallisés 2J et 2H, et ainsi de suite.

Les couches externes 30 renforcent mécaniquement les couches internes 34 et 38 et, en outre, la couche externe 30 disposée contre la couche 34 isole électriquement cette dernière de l'extérieur, sauf bien entendu au niveau des points de connexion que constituent les orifices 1B à 8B et 1C à 8C.

Comme indiqué ci-dessus, le caractère rigide des plaques de circuit-imprimé 31 et 32 permet l'insertion à force des queues déformables 1A à 8A dans les parties d'extrémité 22 et 23 du circuit de compensation 16, les unités 15A et 15B pouvant être ainsi raccordées au circuit 16 sans soudure.

Bien entendu, il est possible, en variante, d'effectuer un raccordement par soudure.

Le caractère souple de la partie centrale 21 permet de disposer aisément tête-bêche les unités de connexion 15A et 15B.

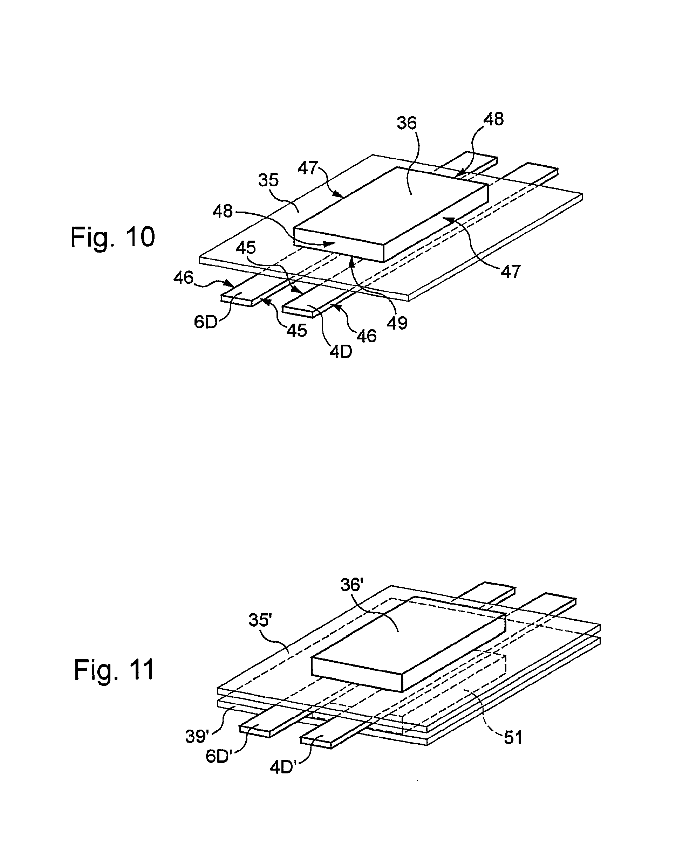

L'agencement relatif du pavé 36 et des pistes conductrices 4D et 6D va maintenant être décrit plus particulièrement à l'appui de la figure 10.

Les pistes conductrices 4D et 6D, disposées sur le substrat 39 (non représenté sur la figure 10), ont chacune la forme d'un ruban à largeur constante. Autrement dit, l'écart entre les deux bords longitudinaux 45 et 46 de chacune des pistes 5D et 6D est constant.

Ici, les pistes 4D et 6D ont la même largeur.

Au voisinage du pavé 36, la piste 4D et 6D sont parallèles l'une à l'autre avec leurs bords 45 longitudinaux internes qui sont directement en regard l'un de l'autre.

Le pavé 36 présente ici une forme rectangulaire avec une largeur (écart entre ses grands côtés 47) qui est sensiblement égale à la distance séparant les bords longitudinaux externes 46 des conducteurs 4D et 6D.

La face principale 49 du pavé 36 située du côté du substrat 35 constitue ainsi une surface comportant une portion qui regarde, au travers du diélectrique que constitue le substrat 35, une surface de même orientation d'un tronçon de la piste conductrice 4D, la surface que forme la face 49 comportant également une autre portion qui regarde, au travers du substrat 35, une surface de même orientation d'un tronçon de la piste conductrice 6D.

Le pavé 36 étant isolé électriquement des pistes conductrices 4D et 6D par le substrat 35, le pavé conducteur 36 diminue les lignes de champs électriques qui relient ces deux conducteurs, ce qui produit, au niveau du pavé 36, un effet capacitif entre les pistes 4D et 6D.

C'est ainsi qu'est réalisé le condensateur repéré par 27B sur la figure 5.

Le condensateur 27C, lui aussi disposé entre les pistes conductrices 4D et 6D, est réalisé de façon semblable par le pavé conducteur 37, l'agencement relatif du pavé 37 et des pistes 4D et 6D étant identique à l'agencement relatif du pavé 36 et des pistes 4D et 6D.

Les condensateurs 26B et 26C couplant les pistes conductrices 3D et 5D sont eux aussi réalisés de façon semblable grâce aux pavés conducteurs 40 et 41, l'agencement relatif des pistes conductrices 3D, 5D et du pavé 40 (respectivement 41) étant semblables à l'agencement relatif des pistes 4D et 6D et du pavé conducteur 36.

On notera que la solution conventionnelle pour réaliser le couplage capacitif entre les pistes 3D et 5D ainsi qu'entre les pistes 4D et 6D aurait été d'employer des pistes conductrices disposées en peigne sur les plaques de circuit imprimé telles que 31 et 32.

Plus précisément, un condensateur formé de deux conducteurs en peigne serait disposé, du côté distal (c'est-à-dire à l'opposé des pistes conductrices), sur l'une des couches telle que 30 entre les trous métallisés 3E et 5E du circuit imprimé tel que 31 et entre les trous métallisés 4F et 6F du circuit imprimé tel que 32, et, sur l'autre couche 30, entre les trous métallisé 4E et 6E du circuit imprimé tel que 31 et entre les trous métallisés 3F et 5F du circuit imprimé tel que 32.

Par rapport à cette solution conventionnelle, le fait de réaliser les couplages avec des pavés conducteurs tels que 36, 37, 40 et 41 offre l'avantage d'effectuer le couplage capacitif sans connexion aux pistes à coupler, et donc avec une surface conductrice de dimensions plus faibles.

Du fait de cette réduction de dimensions, les composants parasites intrinsèques aux couplages capacitifs sont plus faibles et en conséquence le couplage obtenu est plus efficace, ce qui permet au dispositif de raccordement 10 d'offrir de meilleures performances en matière de transmissions, en particulier pour l'adaptation d'impédances de la paire 3-6 et la paradiaphonie entre la paire 3-6 et la paire 4-5.

Comme indiqué ci-dessus, le schéma électrique illustré sur la figure 6 est particulièrement simplifié. Pour la clarté de l'exposé, seuls sont illustrés les couplages capacitifs entre les conducteurs 3D et 5D, d'une part, et entre les conducteurs 4D et 6D, d'autre part.

En réalité, les couplages réalisés entre les différents conducteurs 1 D à 8D sont bien plus complexe, avec notamment une composante inductive entre les différentes pistes conductrices disposées parallèlement à proximité l'une de l'autre.

La figure 11 montre une variante de la portion du circuit de compensation 16 illustrée sur la figure 10. On a gardé les mêmes références numériques pour les éléments similaires, mais affectées d'un exposant '.

Les pistes conductrices 4D' et 6D', le substrat 35' et le pavé 36' sont exactement identiques aux pistes conductrices 4D et 6D, au substrat 35 et au pavé conducteur 36.

Il est en outre prévu, du côté du substrat 39' opposé au côté où sont disposées les pistes conductrices 4D' et 6D', un pavé conducteur 51 semblable au pavé 36' et disposé symétriquement par rapport à celui-ci.

Ainsi, de même que le pavé conducteur 36', le pavé conducteur 51 présente une surface comportant une portion qui regarde, au travers du diélectrique que constitue le substrat 39', une surface de même orientation d'un tronçon de la piste 4D' et une portion qui regarde, au travers du diélectrique que constitue le substrat 39', une surface de même orientation d'un tronçon de la piste 6D', avec le pavé 51 qui est isolé électriquement des pistes 4D' et 6D', de sorte que le pavé 51 procure un couplage capacitif en même temps que le pavé conducteur 36', le couplage capacitif d'ensemble étant donc plus important qu'avec le seul pavé conducteur 36.

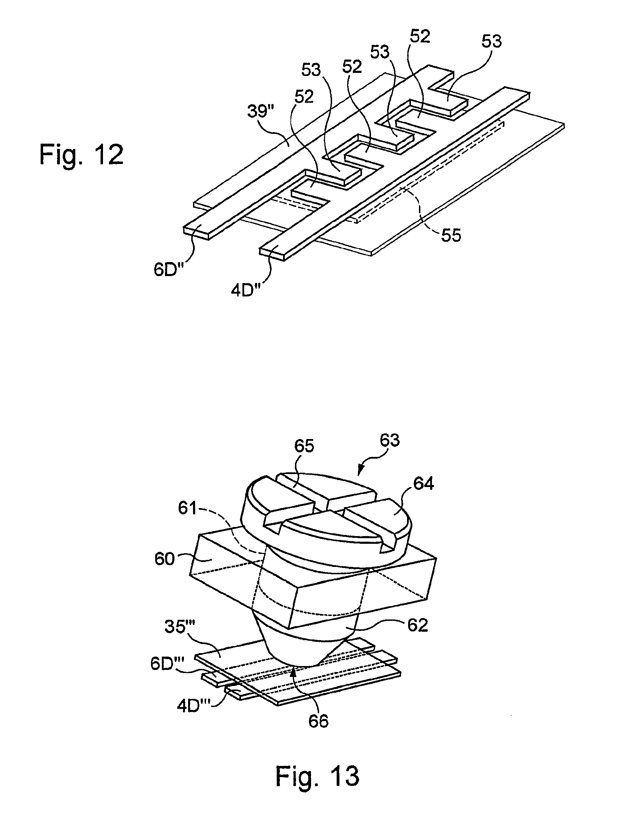

La figure 12 montre une autre variante de la portion du circuit de couplage 16 illustrée sur la figure 10. On a gardé pour les éléments similaires les mêmes références numériques, mais affectées d'un exposant".

Les pistes conductrices 4D" et 6D" sont disposées en peigne, avec ici chacune des pistes 4D" et 6D" qui présente des dents, respectivement 52 et 53, saillant en direction de l'autre piste, ces dents étant disposées de façon imbriquées.

Du côté du substrat 39" opposé à celui où sont disposées les pistes conductrices 4D" et 6D" est prévu un pavé conducteur 55 dont les dimensions sont telles que sa surface tournée vers le substrat 39" est en regard, au travers du diélectrique que constitue le substrat 39", de la totalité des surfaces, de même orientation, des pistes 4D" et 6D", dans la zone où sont prévues les dents 52 et 53.

Ainsi, la surface tournée vers le substrat 39" comporte une portion qui regarde, au travers du substrat 39", une surface de même orientation d'un tronçon de la piste 4D" et une portion qui regarde, dans les mêmes conditions, une surface de même orientation d'un tronçon de la piste 6D".

Le pavé 55 étant isolé électriquement de chacune des pistes conductrices 4D" et 6D", il procure un couplage capacitif entre les pistes 4D" et 6D", qui s'ajoute au couplage capacitif procuré la disposition en peigne de ces pistes conductrices.

La figure 13 montre une autre variante de la portion du circuit de couplage 16 illustrée sur la figure 10. On a gardé pour les éléments similaires les mêmes références numériques, mais affectées d'un exposant"'.

Il est précisé que dans la variante illustrée sur la figure 13, il existe dans le boîtier tel que 11 davantage de place autour du circuit de compensation tel que 16, ce boitier comportant une portion 60 formant écrou et un support (non illustré) permettant aux pistes conductrices 4D"' et 6D"' d'être disposées de façon prédéterminée par rapport à la partie 60.

Cette dernière présente un alésage taraudé 61 dans lequel est engagé le fût fileté 62 d'une vis 63.

La tête 64 de la vis 63 présente une empreinte 65 permettant de commander la position angulaire de la vis 63 par rapport à la partie 60.

La surface d'extrémité 66 de la vis 63 est disposée au droit des pistes conductrices 4D"' et 6D"', le substrat 35"' et la lame d'air située entre la surface 66 et le substrat 35"' constituant un diélectrique.

Une portion de la surface 66 regarde, au travers de ce diélectrique, une surface de même orientation d'un tronçon de la piste 4D"' et une autre portion de la surface 66 regarde, au travers de ce diélectrique, une surface de même orientation d'un tronçon de la piste conductrice 6D"'.

La vis 63 étant isolée électriquement des pistes 4D"' et 6D"', procure un couplage capacitif entre ces pistes.

En faisant varier la position angulaire de la vis 63, on fait varier l'épaisseur de la lame d'air existant entre le substrat 35"' et la surface 66.

On fait ainsi varier la valeur du couplage capacitif réalisé. Cela permet un ajustement fin de ce couplage capacitif.

On notera qu'il est également possible de réaliser un ajustement fin des valeurs de couplage capacitif grâce à des pavés'de matière conductrice tels que les pavés 36, 37, 40 et 41, en ajustant les dimensions de ces pavés, par exemple par volatilisation grâce à un faisceau laser.

On observera qu'une telle volatilisation, du fait qu'elle est pratiquée sur un élément qui ne sert pas au cheminement direct d'un courant électrique, ne produit aucune restriction de la section de cheminement d'un tel courant.

Dans une variante non illustrée, la conformation des deux pistes conductrices à coupler de façon capacitive et/ou la conformation du ou des élément(s) conducteur(s) est encore différente, avec par exemple les pistes conductrices qui présentent des changements de direction et le pavé conducteur qui est isolé électriquement des deux pistes conductrices et qui présente des décrochements, avec à chaque fois l'élément conducteur qui présente une surface comportant une portion en regard, au travers d'un diélectrique, d'une surface d'un tronçon d'une piste conductrice et une autre portion en regard, au travers d'un diélectrique, d'une surface d'un tronçon de l'autre piste conductrice.

Dans une autre variante non illustrée, l'élément conducteur est réalisé différemment d'un pavé conducteur disposé sur un substrat ou d'une vis dont la surface d'extrémité regarde les pistes conductrices.

On notera que la précision du couplage capacitif réalisé dépend de la tolérance de l'épaisseur de diélectrique entre les pistes conductrices et la surface de l'élément conducteur ; et que le couplage sera d'autant plus efficace que cette épaisseur est faible.

Il est ainsi avantageux d'utiliser un circuit souple, et plus précisément un substrat tel que 35, 35', 39" ou 35", de très faible épaisseur (25 ou 50 µm) et à tolérance d'épaisseur réduite (de l'ordre de 2%).

Bien entendu, il est possible de réaliser des couplages capacitifs avec des pavés conducteurs tels que 36, 37, 40 et 41 pour d'autres portions d'un circuit de compensation tel que 16.

Dans d'autres variantes non illustrées, le circuit de compensation est réalisé différemment, par exemple avec des couches doubles faces plutôt que simples faces ; en étant entièrement rigide ou entièrement souple ; et/ou en étant réalisé par sérigraphie multicouches ou surmoulage multibandes.

Dans encore d'autres variantes non illustrées, les unités de connexion reliées par le circuit de compensation sont d'un autre type, par exemple une unité telle que 15A ou 15B et un bornier de raccordement à un câble mural ; deux borniers de raccordement à un tel câble ; et/ou au moins une unité connexion à un autre format tel que RJ12 ou Sub-D.

## Revendications

1. Dispositif de raccordement pour réseau local, comportant deux unités de connexion (15A, 15B) et un circuit de compensation (16) muni de points de connexion (1B-8B, 1C-8C) pour des contacts (1A-8A) que comportent lesdites unités de connexion (15A, 15B) et des pistes conductrices (1D-8D) pour relier deux à deux lesdits points de connexion, ledit circuit (16) comportant des moyens de couplage capacitif entre au moins une première dite piste conductrice (3D, 4D ; 4D' ; 4D" ; 4D"') et une seconde dite piste conductrice (5D, 6D ; 6D' ; 6D" ; 6D"') ; **caractérisé en ce que** lesdits moyens de couplage capacitif comportent un élément conducteur (36, 37, 40, 41 ; 36', 51 ; 55 ; 63) isolé électriquement desdites première piste (3D, 4D ; 4D' ; 4D" ; 4D"') et seconde piste (5D, 6D ; 6D' ; 6D" ; 6D"') tandis qu'il présente une surface (49 ; 66) comportant une portion en regard, au travers d'un diélectrique (35 ; 35', 39' ; 39" ; 35"'), d'une surface de même orientation d'un tronçon de la première piste et une autre portion en regard, au travers dudit diélectrique (35 ; 35' ; 39' ; 39" ; 35"'), d'une surface de même orientation d'un tronçon de la seconde piste.

2. Dispositif selon la revendication 1, **caractérisé en ce que** ledit diélectrique comporte un substrat (35 ; 35', 39' ; 39" ; 35"') interposé entre ledit élément conducteur (36, 37, 40, 41 ; 36', 51 ; 55 ; 63) et lesdites première piste (3D, 4D ; 4D' ; 4D" ; 4D"') et seconde piste (5D, 6D ; 6D' ; 6D" ; 6D"').

3. Dispositif selon l'une quelconque des revendications 1 ou 2, **caractérisé en ce que** ledit diélectrique comporte une matière souple en feuille (35 ; 35', 39' ; 39" ; 35"').

4. Dispositif selon la revendication 3, **caractérisé en ce que** ledit matériau souple en feuille (35 ; 35', 39' ; 39" ; 35"') est conformé en une bande.

5. Dispositif selon l'une quelconque des revendications 1 à 4, **caractérisé en ce que** ledit tronçon de la première piste (3D, 4D ; 4D' ; 4D"') et ledit tronçon de la seconde piste (5D, 6D ; 6D' ; 6D" ; 6D"') ont la forme d'un ruban.

6. Dispositif selon la revendication 5, **caractérisé en ce que** ledit tronçon de la première piste (3D, 4D ; 4D' ; 4D"') et ledit tronçon de la seconde piste (5D, 6D ; 6D' ; 6D" ; 6D"') sont parallèles l'un à l'autre avec leurs bords longitudinaux internes (45) qui sont directement en regard l'un de l'autre.

7. Dispositif selon l'une quelconque des revendications 1 à 4, **caractérisé en ce que** ledit tronçon de la première piste (4D") et ledit tronçon de la seconde piste (6D") sont disposés en peigne, avec chacune desdites première piste (4D") et seconde piste (6D") qui présentent des dents (52, 53) disposées de façon imbriquée.

8. Dispositif selon l'une quelconque des revendications 1 à 7, **caractérisé en ce que** ledit élément conducteur est un pavé (36, 37, 40, 41 ; 36', 51 ; 55) comportant une face principale (49) formant ladite surface.

9. Dispositif selon la revendication 8, **caractérisé en ce que** ledit pavé (36, 37, 40, 41 ; 36', 51 ; 55) est rectangulaire.

10. Dispositif selon l'une quelconque des revendications 1 à 7, caractérisées ledit élément conducteur est une vis (63) dont ladite surface (66) est située à une extrémité.

11. Dispositif selon la revendication 10, **caractérisé en ce qu'**il comporte une portion (60) formant écrou dans laquelle est reçu le fût (62) de ladite vis (63), grâce à quoi la distance entre ladite surface d'extrémité (66) et lesdites première piste conductrice (4D"') et seconde piste conductrice (6D"') peut être ajustée.

12. Dispositif selon l'une quelconque des revendications 1 à 11, **caractérisé en ce que** ledit circuit de compensation (16) comporte une partie centrale (21) qui est souple et deux parties d'extrémité (22, 23) qui sont rigides.

13. Dispositif selon la revendication 12, **caractérisé en ce que** lesdits points de connexion (1B-8B, 1C-8C) sont prévus dans lesdites parties d'extrémité (22, 23).

14. Dispositif selon l'une quelconque des revendications 1 à 13, **caractérisé en ce qu'**au moins une desdites unités de connexion est une unité de connexion (15A, 15B) pour une prise femelle RJ45.

15. Dispositif selon la revendication 14, **caractérisé en ce que** les deux dites unités de connexion sont des unités de connexion (15A, 15B) pour une prise femelle RJ45.

16. Dispositif selon l'une quelconque des revendications 1 à 15, **caractérisé en ce qu'**il comporte au moins un logement (12A, 12B) d'accueil d'une fiche mâle RJ45.

17. Dispositif selon la revendication 16, **caractérisé en ce qu'**il comporte deux logements d'accueil (12A, 12B) d'une fiche mâle RJ45 débouchant respectivement dans l'une et l'autre de deux faces opposées (13A, 13B) d'un boîtier (11).

## Patentansprüche

1. LAN-Anschlussvorrichtung mit zwei Anschlusseinheiten (15A, 15B) und einer Kompensationsschaltung (16), die mit Anschlusspunkten (1B-8B, 1C-8C) für Kontakte (1A-8A), welche die Anschlusseinheiten (15A, 15B) aufweisen, und Leiterbahnen (1 D-8D) zum paarweisen Verbinden der Anschlusspunkte versehen ist, wobei die Schaltung (16) Mittel zur kapazitiven Kopplung zwischen wenigstens einer erste Leiterbahn (3D, 4D; 4D'; 4D"; 4D"') und einer zweiten Leiterbahn (5D, 6D; 6D'; 6D"; 6D"') aufweist,
**dadurch gekennzeichnet, dass** die kapazitiven Kopplungsmittel ein leitendes Element (36, 37, 40, 41; 36', 51; 55; 63) umfassen, das von der ersten Leiterbahn (3D, 4D; 4D'; 4D"; 4D"') und der zweiten Leiterbahn (5D, 6D; 6D'; 6D"; 6D"') elektrisch isoliert ist, während es eine Fläche (49; 66) aufweist, die einen Teil umfasst, der durch ein Dielektrikum (35; 35', 39'; 39"; 35"') auf eine Fläche gleicher Ausrichtung eines Abschnitts der ersten Leiterbahn gerichtet ist, und einen anderen Teil, der durch das Dielektrikum (35; 35', 39'; 39"; 35"') auf eine Fläche gleicher Ausrichtung eines Abschnitts der zweiten Leiterbahn gerichtet ist.

2. Vorrichtung nach Anspruch 1,
**dadurch gekennzeichnet, dass** das Dielektrikum ein Substrat (35; 35', 39'; 39", 35"') aufweist, das zwischen das leitende Element (36, 37, 40, 41; 36', 51; 55; 63) und die erste Leiterbahn (3D, 4D; 4D'; 4D"; 4D"') und die zweite Leiterbahn (5D, 6D; 6D'; 6D"; 6D"') eingefügt ist.

3. Vorrichtung nach einem der Ansprüche 1 oder 2,
**dadurch gekennzeichnet, dass** das Dielektrikum ein flexibles Folienmaterial (35; 35', 39'; 39"; 35"') umfasst.

4. Vorrichtung nach Anspruch 3,
**dadurch gekennzeichnet, dass** das flexible Folienmaterial (35; 35', 39'; 39"; 35"') in einem Streifen ausgebildet ist.

5. Vorrichtung nach einem der Ansprüche 1 bis 4,
**dadurch gekennzeichnet, dass** der Abschnitt der ersten Leiterbahn (3D, 4D; 4D'; 4D"') und der Abschnitt der zweiten Leiterbahn (5D, 6D; 6D'; 6D"; 6D"') die Form eines Bandes haben.

6. Vorrichtung nach Anspruch 5,
**dadurch gekennzeichnet, dass** der Abschnitt der ersten Leiterbahn (3D, 4D; 4D', 4D"') und der Abschnitt der zweiten Leiterbahn (5D, 6D; 6D'; 6D"; 6D"') mit ihren inneren Längsrändern (45), die einander direkt gegenüber liegen, zueinander parallel sind.

7. Vorrichtung nach einem der Ansprüche 1 bis 4,
**dadurch gekennzeichnet, dass** der Abschnitt der ersten Leiterbahn (4D") und der Abschnitt der zweiten Leiterbahn (6D") kammförmig angeordnet sind, wobei die erste Leiterbahn (4D") und die zweite Leiterbahn (6D") jeweils überlappend angeordnete Stifte (52, 53) aufweisen.

8. Vorrichtung nach einem der Ansprüche 1 bis 7,
**dadurch gekennzeichnet, dass** das leitende Element ein Leiterblock (36, 37, 40, 41; 36', 51; 55) ist, der eine die Fläche bildende Hauptstirnseite (49) aufweist.

9. Vorrichtung nach Anspruch 8,
**dadurch gekennzeichnet, dass** der Leiterblock (36, 37, 40, 41; 36', 51; 55) rechteckig ist.

10. Vorrichtung nach einem der Ansprüche 1 bis 7,
**dadurch gekennzeichnet, dass** das leitende Element eine Schraube (63) ist, deren Fläche (66) sich an einem Ende befindet.

11. Vorrichtung nach Anspruch 10,
**dadurch gekennzeichnet, dass** sie einen eine Mutter bildenden Teil (60) umfasst, in den der Schaft (62) der Schraube (63) aufgenommen ist, wodurch der Abstand zwischen der Endfläche (66) und der ersten Leiterbahn (4D"') und der zweiten Leiterbahn (6D"') verändert werden kann.

12. Vorrichtung nach einem der Ansprüche 1 bis 11,
**dadurch gekennzeichnet, dass** die Kompensationsschaltung (16) ein flexibles Mittelteil (21) und zwei starre Endteile (22, 23) umfasst.

13. Vorrichtung nach Anspruch 12,
**dadurch gekennzeichnet, dass** die Anschlusspunkte (1B-8B, 1C-8C) in den Endteilen (22, 23) vorgesehen sind.

14. Vorrichtung nach einem der Ansprüche 1 bis 13,
**dadurch gekennzeichnet, dass** wenigstens eine Anschlusseinheit eine Anschlusseinheit (15A, 15B) für eine RJ45-Buchse ist.

15. Vorrichtung nach Anspruch 14,
**dadurch gekennzeichnet, dass** beide Anschlusseinheiten Anschlusseinheiten (15A, 15B) für RJ45-Buchsen sind.

16. Vorrichtung nach einem der Ansprüche 1 bis 15,
**dadurch gekennzeichnet, dass** sie wenigstens eine Aufnahme (12A, 12B) für einen RJ45-Stecker umfasst.

17. Vorrichtung nach Anspruch 16,
**dadurch gekennzeichnet, dass** sie zwei Aufnahmen (12A, 12B) für einen RJ45-Stecker umfasst, die jeweils in die eine bzw. die andere der beiden entgegengesetzt angeordneten Seiten (13A, 13B) eines Gehäuses (11) münden.

## Claims

1. Local area network connection device, including two connection units (15A, 15B) and a compensation circuit (16) provided with connection points (1B-8B, 1C-8C) for contacts (1A-8A) of said connection units (15A, 15B) and conductive tracks (1D-8D) for connecting said connection points two-by-two, said circuit (16) including capacitive coupling means between at least a first of said conductive tracks (3D, 4D; 4D'; 4D" ; 4D"') and a second of said conductive tracks (5D, 6D; 6D'; 6D"; 6D"'); **characterized in that** said capacitive coupling means include a conductive element (36, 37, 40, 41; 36', 51; 55; 63) electrically insulated from said first track (3D, 4D; 4D'; 4D"; 4D"') and said second track (5D, 6D; 6D'; 6D" ; 6D"') while it features a surface (49; 66) including a portion facing, through a dielectric (35; 35', 39'; 39"; 35"'), a surface with the same orientation of a section of the first track and another portion facing, through said dielectric (35; 35'; 39'; 39"; 35"'), a surface with the same orientation of a section of the second track.

2. Device according to claim 1, **characterized in that** said dielectric includes a substrate (35; 35', 39'; 39"; 35"') disposed between said conductive element (36, 37, 40, 41; 36', 51; 55; 63) and said first track (3D, 4D; 4D'; 4D"; 4D"') and said second track (5D, 6D; 6D'; 6D"; 6D"').

3. Device according to either of claims 1 or 2, **characterized in that** said dielectric includes a flexible film material (35; 35', 39'; 39"; 35"').

4. Device according to claim 3, **characterized in that** said flexible film material (35; 35', 39'; 39"; 35"') is conformed as a strip.

5. Device according to any one of claims 1 to 4, **characterized in that** said section of the first track (3D, 4D; 4D'; 4D"') and said section of the second track (5D, 6D; 6D'; 6D"; 6D"') take the form of a ribbon.

6. Device according to claim 5, **characterized in that** said section of the first track (3D, 4D; 4D'; 4D"') and said section of the second track (5D, 6D; 6D'; 6D"; 6D"') are parallel to each other with their internal longitudinal edges (45) which are directly facing each other.

7. Device according to any one of claims 1 to 4, **characterized in that** said section of the first track (4D") and said section of the second track (6D") are disposed in a comb-like manner, with said first track (4D") and said second track (6D") each having teeth (52, 53) disposed in an interleaved manner.

8. Device according to any one of claims 1 to 7, **characterized in that** said conductive element is a block (36, 37, 40, 41; 36', 51; 55) including a main face (49) forming said surface.

9. Device according to claim 8, **characterized in that** said block (36, 37, 40, 41; 36', 51; 55) is rectangular.

10. Device according to any one of claims 1 to 7, **characterized in that** said conductive element is a screw (63) said surface (66) of which is situated at one end.

11. Device according to claim 10, **characterized in that** it includes a portion (60) forming a nut in which is received the shank (62) of said screw (63), thanks to which the distance between said end surface (66) and said first conductive track (4D"') and said second conductive track (6D"') can be adjusted.

12. Device according to any one of claims 1 to 11, **characterized in that** said compensation circuit (16) includes a central part (21) which is flexible and two end parts (22, 23) which are rigid.

13. Device according to claim 12, **characterized in that** said connection points (1B-8B, 1C-8C) are provided in said end parts (22, 23).

14. Device according to any one of claims 1 to 13, **characterized in that** at least one of said connection units is a connection unit (15A, 15B) for an RJ45 female socket.

15. Device according to claim 14, **characterized in that** said two connection units are connection units (15A, 15B) for an RJ45 female socket.

16. Device according to any one of claims 1 to 15, **characterized in that** it includes at least one receptacle (12A, 12B) for receiving an RJ45 male plug.

17. Device according to claim 16, **characterized in that** it includes two receptacles (12A, 12B) for receiving an RJ45 male plug respectively opening onto one and the other of two opposite faces (13A, 13B) of a casing (11).
